# FASCICULE DE BREVET EUROPEEN

(11) **EP 3 195 322 B1**
(45) Date de publication et mention de la délivrance du brevet: **10.10.2018**
(21) Numéro de dépôt: 15790167.9
(22) Date de dépôt: 16.09.2015
(51) Int. Cl.: G21C 3/06, G21C 3/07, G21C 21/02, B32B 15/01, C23C 28/02, C23C 14/02, C23C 14/16, C23C 14/34, C23C 14/35, C22C 16/00, G21C 3/20

(54) **GAINES DE COMBUSTIBLE NUCLÉAIRE, PROCÉDÉ DE FABRICATION ET UTILISATIONS CONTRE L'OXYDATION/HYDRURATION**
KERNBRENNSTOFFHÜLLEN, HERSTELLUNGSVERFAHREN DAFÜR UND VERWENDUNGEN DAVON GEGEN OXIDIERUNG/HYDRIERUNG
NUCLEAR FUEL CLADDINGS, PRODUCTION METHOD THEREOF AND USES OF SAME AGAINST OXIDATION/HYDRIDING

(30) Priorité: 17.09.2014 US 201462051913 P
(43) Date de publication de la demande: 26.07.2017
(73) Titulaire: Commissariat à l'Énergie Atomique et aux Énergies Alternatives, 75015 Paris (FR)
(72) Inventeur: BRACHET, Jean-Christophe, 91140 Villebon-Sur-Yvette (FR); BILLARD, Alain, 25400 Exincourt (FR); SCHUSTER, Frédéric, 78100 St Germain-en-Laye (FR); LE FLEM, Marion, 92260 Fontenay Aux Roses (FR); IDARRAGA-TRUJILLO, Isabel, 71000 Macon (FR); LE SAUX, Matthieu, 91300 Massy (FR); LOMELLO, Fernando, 91190 Gif-sur-Yvette (FR)
(74) Mandataire: Dennemeyer & Associates S.A.
(86) Numéro de dépôt international: PCT/FR2015/052475
(87) Numéro de publication internationale: WO 2016/042261

(56) Documents cités:
- EP-A1- 0 624 882
- WO-A1-2013/160587
- US-A1- 2013 209 834
- Ati Wah Chang: "Reactor Grade Zirconium Alloys for Nuclear Waste Disposal ZIRCONIUM ALLOYS", , 21 novembre 2003 (2003-11-21), pages 1-4, XP055236698, Extrait de l'Internet: URL:http://www.atimetals.com/businesses/at ispecialtyalloysandcomponents/products/Doc uments/Zr nuke waste disposal.pdf [extrait le 2015-12-16]

## Description

### DOMAINE TECHNIQUE

La présente invention appartient au domaine des matériaux mis en oeuvre dans le domaine nucléaire, en particulier les matériaux destinés à résister au mieux aux conditions physico-chimiques rencontrées en conditions nominales et lors d'un scénario accidentel de réacteur nucléaire, tel que par exemple un Réacteur à Eau sous Pression (REP), un Réacteur à Eau Bouillante (REB) ou un réacteur de type « Canadian Deuterium Uranium » (CANDU).

L'invention concerne plus particulièrement des gaines de combustible nucléaire, leurs procédés de fabrication et utilisations contre l'oxydation et/ou l'hydruration.

### ARRIERE-PLAN TECHNIQUE

L'alliage de zirconium constitutif des gaines de combustible nucléaire s'oxyde au contact de l'eau constituant le caloporteur des réacteurs nucléaires REP, REB ou de type CANDU.

Différentes solutions sont proposées afin d'améliorer la résistance à la corrosion d'une gaine de combustible nucléaire comprenant un alliage de zirconium. Le document « EP 0624882 A1 » décrit par exemple une gaine de combustible nucléaire d'un réacteur de type REB qui vise à améliorer la résistance à la propagation des fissures et à la corrosion, cette gaine comprenant des couches à base de zirconium et de précipités intermétalliques.

Lors de l'oxydation d'un alliage de zirconium, l'oxyde formé est fragile et la prise d'hydrogène associée à l'oxydation conduit à la précipitation d'hydrures de zirconium qui sont fragilisants. La durée de vie des gaines est alors en grande partie limitée par l'épaisseur maximale d'oxyde acceptable et la teneur en hydrogène absorbé associé. Pour garantir de bonnes propriétés mécaniques résiduelles de la gaine visant à assurer un confinement optimal du combustible nucléaire, l'épaisseur résiduelle d'alliage de zirconium sain et ductile doit être suffisante et la fraction d'hydrures suffisamment limitée.

La possibilité de limiter ou de retarder une telle oxydation et/ou l'hydruration peut donc s'avérer cruciale en conditions accidentelles.

Ces conditions sont par exemple atteintes dans le cas de scénarios hypothétiques accidentels type « RIA » (pour "Reactivity Insertion Accident") ou « APRP » (Accident de Perte de Réfrigérant Primaire), voire en conditions de dénoyage de la piscine de stockage de combustible usé. Elles se caractérisent notamment par de hautes températures qui sont généralement supérieures à 700 °C, en particulier comprises entre 800 °C et 1200 °C, et qui peuvent être atteintes avec une vitesse élevée de montée en température. À de telles températures, le caloporteur se présente sous forme de vapeur d'eau.

L'oxydation en conditions accidentelles est beaucoup plus critique qu'en conditions de fonctionnement normal du réacteur nucléaire, car la détérioration du gainage, première barrière de confinement du combustible, est plus rapide et les risques associés plus importants. Ces risques sont notamment les suivants :
- dégagement d'hydrogène ;
- fragilisation du gainage à haute température, par l'oxydation voire, dans certaines conditions, l'hydruration du gainage ;
- fragilisation du gainage à la trempe, provoquée par la diminution brutale de température lors de l'apport massif d'eau pour la mise en sécurité du coeur du réacteur nucléaire ;
- faible tenue mécanique du gainage après la trempe ou le refroidissement, en cas notamment d'opérations de manutention après accident, de répliques de séismes,....

Compte tenu de ces risques, il est essentiel de limiter au mieux l'oxydation et/ou l'hydruration à haute température du gainage afin d'améliorer la sûreté des réacteurs nucléaires utilisant notamment l'eau comme caloporteur.

La solution proposée par la demande de brevet « WO 2013/160587 » consiste à réaliser une gaine de combustible nucléaire dans laquelle le substrat à base de zirconium est recouvert d'un revêtement multicouche comprenant des couches métalliques composées de chrome, d'un alliage de chrome et/ou d'un alliage ternaire du système Nb-Cr-Ti.

Néanmoins, des expérimentations complémentaires ont montré que la résistance à l'oxydation à haute température, bien qu'améliorée par rapport aux gainages antérieurs, s'avère insuffisante à très haute température, typiquement pour des températures supérieures ou égales à 1200 °C lorsque le dépôt du revêtement multicouche sur le substrat à base de zirconium a été réalisé par un procédé de dépôt physique en phase vapeur (PVD) par pulvérisation cathodique magnétron de type conventionnel.

Ces très hautes températures se situent à l'extrême voire au-delà de celles des hautes températures comprises entre 700 °C et 1200 °C qui sont fixées par les conditions réglementaires accidentelles.

Or, les critères réglementaires régissant les accidents de dimensionnement selon le scénario de type « APRP » défini dès les années 1970 imposaient que la température maximale de la gaine ne dépasse pas 1204 °C (2200 °F) et un taux d'oxydation « ECR » maximal de 17 %.

Le taux d'oxydation « ECR » (« Equivalent Cladding Reacted ») est le pourcentage d'épaisseur de gaine métallique transformée en zircone (ZrO₂) résultant de l'oxydation du zirconium contenu dans la gaine de combustible nucléaire, en faisant l'hypothèse que tout l'oxygène qui a réagi forme de la zircone stoechiométrique.

Pour tenir compte de l'effet fragilisant supplémentaire lié à l'hydruration en service du gainage, ce taux d'oxydation « ECR » résiduel acceptable peut désormais être largement inférieur à 17 % dans certaines conditions, telles que par exemple un gainage hydruré en service jusqu'à plusieurs centaines de ppm massique, ce qui correspond en pratique à une durée d'oxydation du gainage qui ne doit pas excéder quelques minutes à 1200 °C.

Une amélioration de la résistance à l'oxydation et/ou l'hydruration à très haute température permettrait avantageusement d'obtenir des marges de sécurité supplémentaires, notamment en évitant ou retardant d'autant plus la détérioration du gainage en cas d'aggravation ou de persistance de la situation accidentelle.

### EXPOSE DE L'INVENTION

Un des buts de l'invention est donc d'éviter ou d'atténuer un ou plusieurs des inconvénients décrits ci-dessus, en proposant une gaine de combustible nucléaire et son procédé de fabrication qui permette d'améliorer la résistance à l'oxydation et/ou l'hydruration, notamment en présence de vapeur d'eau.

Un autre but de l'invention est d'améliorer cette résistance à l'oxydation et/ou l'hydruration à très haute température, à savoir au-delà de 1200 °C, particulièrement entre 1200 °C et 1400 °C, plus particulièrement entre 1200 °C et 1300 °C ; notamment lorsque ces températures sont atteintes avec une vitesse de montée en température qui est comprise entre 0,1 °C/secondes et 300 °C/secondes.

Un autre but de l'invention est d'améliorer la durée de la résistance à l'oxydation et/ou l'hydruration, durée au-delà de laquelle le confinement du combustible nucléaire n'est plus assuré.

La présente invention concerne ainsi un procédé de fabrication d'une gaine de combustible nucléaire comprenant i) un substrat contenant une couche interne à base de zirconium revêtue ou non d'au moins une couche intercalaire placée sur la couche interne, et ii) au moins une couche externe placée sur le substrat et composée d'une matière protectrice choisie parmi le chrome ou un alliage à base de chrome ; le procédé comprenant les étapes successives suivantes :
a) décapage ionique de la surface du substrat ;
b) dépôt de la au moins une couche externe sur le substrat avec un procédé de pulvérisation cathodique magnétron par impulsions de forte puissance (HiPIMS) dans lequel la cathode magnétron est composée de la matière protectrice.

En comparaison avec les procédés de l'état de la technique, le procédé de fabrication de l'invention a notamment pour particularité qu'il utilise un procédé de pulvérisation cathodique magnétron par impulsions de forte puissance (dit HiPIMS pour « High Power Impulse Magnetron Sputtering ») afin de déposer selon l'étape b) la au moins une couche externe à base de chrome sur la couche interne à base de zirconium. Un tel procédé est connu de l'homme du métier, et décrit par exemple dans le document « *Techniques de l'ingénieur, La pulvérisation cathodique magnétron en régime d'impulsions de haute puissance (HiPIMS) pulvérisation cathodique magnétron, Référence IN207* ».

Le procédé de pulvérisation HiPIMS se distingue des procédés conventionnels de pulvérisation cathodique magnétron par de nombreux aspects.

Conformément au procédé de pulvérisation cathodique magnétron conventionnel tel qu'utilisé dans « WO 2013/160587 » (mentionné ci-après en tant que procédé de PVD magnétron conventionnel), une différence de potentiel est appliquée entre une cible de chrome polarisée négativement (cathode magnétron) et les parois du réacteur de pulvérisation cathodique qui sont reliées à la masse.

Pour ce type de procédé, la tension continue de polarisation appliquée à la cible est typiquement comprise entre -600 V et -200 V. Le courant de décharge est de quelques ampères.

Dans ces conditions, l'atmosphère raréfiée, généralement composée d'argon, est alors partiellement ionisée et forme un plasma froid. Elle comprend alors essentiellement des atomes d'argon Ar et une faible proportion d'ions argon Ar⁺, mais pas d'ions métalliques ou en quantité infinitésimale très inférieure à 10⁻⁶. Les ions Ar⁺ sont ensuite accélérés par le champ électrique de la cible qu'ils impactent, ce qui conduit à l'éjection d'atomes de chrome qui se déposent sur le substrat à revêtir qui fait généralement face à la cible.

Le procédé de pulvérisation HiPIMS se différencie en particulier du procédé PVD magnétron conventionnel utilisé dans « WO 2013/160587 » par plusieurs caractéristiques, notamment :
- des impulsions de polarisation à haute fréquence sont appliquées à la cible de chrome constituant la cathode magnétron. Les impulsions durent par exemple de 1/1000 à 1/100 de la durée totale de polarisation ;
- la puissance instantanée délivrée par chaque impulsion est de plusieurs dizaines de kilowatts à quelques mégawatts. Ceci conduit à l'éjection en grande quantité d'ions métalliques Cr⁺, bien que la puissance moyennée sur toute la durée de polarisation soit au plus de quelques kilowatts, par exemple inférieure à 1,2 kW ;
- la production d'une atmosphère composée essentiellement d'ions métalliques Cr⁺.

De manière inattendue, les inventeurs ont découvert qu'une gaine de combustible nucléaire obtenue par le procédé de fabrication de l'invention permettait de lui conférer une résistance à l'oxydation et/ou hydruration améliorée, en particulier à très haute température, notamment en présence de vapeur d'eau.

De telles propriétés ne peuvent être anticipées au regard des spécificités chimiques et métallurgiques du zirconium et des alliages de zirconium utilisés pour les applications nucléaires, notamment leur composition chimique, état de surface, texture cristalline, état métallurgique final (écroui ou plus ou moins recristallisé), propriétés qui sont susceptibles d'influencer la qualité et le comportement des revêtements.

En particulier, la phase α d'un alliage de zirconium (notée « Zr-α », de structure cristallographique hexagonale compacte) à basse température se transforme en phase β (notée « Zr-β », de structure cristallographique cubique centrée) dans une gamme de température allant typiquement de 700 °C à 1000 °C. En passant de la structure Zr-α à la structure cubique Zr-β, l'alliage subit des variations dimensionnelles locales. Ces variations sont a priori défavorables à la tenue mécanique d'une couche externe qui recouvrirait une couche interne à base de zirconium, en raison notamment de l'incompatibilité de leurs coefficients de dilatation. Ces difficultés d'adhérence sont accentuées par les mécanismes de diffusion d'espèces chimiques qui sont plus rapides dans la phase Zr-β que dans la phase Zr-α, et qui peuvent modifier l'interface entre le substrat et son revêtement.

L'invention concerne également une gaine de combustible nucléaire obtenue ou susceptible d'être obtenue par le procédé de fabrication de l'invention.

L'invention concerne également une gaine de combustible nucléaire avec couche d'interface comprenant :
i) un substrat contenant une couche interne composée d'un alliage de zirconium comprenant en masse de 100 ppm à 3000 ppm de fer ;
ii) au moins une couche externe placée sur le substrat et composée d'une matière protectrice choisie parmi le chrome ou un alliage à base de chrome, et ;
iii) une couche d'interface disposée entre la couche interne et la couche externe et composée d'une matière interfaciale comprenant au moins un composé intermétallique choisi parmi ZrCr₂ de structure cristalline cubique, Zr(Fe,Cr)₂ de structure cristalline hexagonale ou ZrFe₂ de structure cristalline cubique.

La couche d'interface se forme lors du dépôt HiPIMS selon l'étape b) de la couche externe sur le substrat en absence d'au moins une couche intercalaire placée sur la couche interne et lorsque l'alliage de zirconium constitutif de la couche interne comprend en masse de 100 ppm à 3000 ppm de fer. Naturellement, elle est donc plus particulièrement positionnée entre la couche interne et la première couche externe.

De manière inattendue, elle ne dégrade pas l'adhérence de la couche externe vis-à-vis du substrat, alors que les composés intermétalliques sont connus pour leurs propriétés mécaniques de type fragile.

De plus, sous oxydation en présence de vapeur d'eau, à haute température voire très haute température (par exemple à 1200 °C), les inventeurs ont constaté que la couche interfaciale comprenant en majorité ou en totalité au moins un composé intermétallique s'épaissit. Là encore de manière inattendue, aucune desquamation généralisée n'est constatée malgré la fragilité intrinsèque supposée d'un composé intermétallique et les contraintes interfaciales qui peuvent théoriquement se développer lors des étapes de fabrication voire ultérieurement en service et/ou en conditions nominales ou dans certaines conditions accidentelles.

Préférentiellement, la couche d'interface a une épaisseur moyenne de 10 nm à 1 µm.

L'invention concerne également une gaine de combustible nucléaire composite comprenant i) un substrat contenant une couche interne à base de zirconium et au moins une couche intercalaire placée sur la couche interne et composée d'au moins une matière intercalaire choisie parmi le tantale, le molybdène, le tungstène, le niobium, le vanadium, le hafnium ou leurs alliages et ii) au moins une couche externe placée sur le substrat et composée d'une matière protectrice choisie parmi le chrome ou un alliage de chrome.

Dans ce cas, la matière intercalaire ou la matière protectrice peut être respectivement déposée sur la couche interne ou sur le substrat par tout type de procédé, par exemple un procédé de dépôt physique en phase vapeur par pulvérisation cathodique magnétron différent du procédé de pulvérisation HiPIMS.

Ces types de gaines de combustible nucléaire selon l'invention, à savoir obtenue ou susceptible d'être obtenue par le procédé de fabrication de l'invention, composite ou non, ou avec couche d'interface peuvent se présenter selon une ou plusieurs des variantes décrites dans la présente description pour le procédé de fabrication de l'invention précité, notamment les variantes relatives à la structure et/ou à la composition d'une gaine de combustible nucléaire.

Ces variantes concernent notamment et pas exclusivement : la couche interne, le revêtement interne, la composition de l'alliage de zirconium ou de l'alliage de chrome, la structure de la couche externe tels qu'ils sont détaillés dans la présente description, notamment la description du procédé de fabrication de l'invention.

La géométrie de ces gaines est telle qu'elles peuvent se présenter sous forme d'un tube, ou d'une plaque résultant plus particulièrement de l'assemblage de deux sous-unités.

L'invention concerne également un procédé de fabrication d'une gaine de combustible nucléaire composite, comprenant les étapes successives suivantes :
A) obtention d'un substrat par dépôt sur une couche interne à base de zirconium d'au moins une couche intercalaire composée d'au moins une matière intercalaire choisie parmi le tantale, le molybdène, le tungstène, le niobium, le vanadium, le hafnium ou leurs alliages ;
B) dépôt sur le substrat d'au moins une couche externe composée d'une matière protectrice choisie parmi le chrome ou un alliage de chrome.

Le dépôt selon l'étape A) et/ou B) peut être réalisé par un dépôt physique en phase vapeur ou une électrolyse pulsée.

Le dépôt physique en phase vapeur peut être une pulvérisation cathodique, plus particulièrement de type magnétron, encore plus particulièrement un procédé de pulvérisation HiPIMS de préférence selon une ou plusieurs des caractéristiques indiquées dans la présente description.

Lorsque la couche intercalaire est composée de hafnium, son épaisseur est de 1 nm à 1 µm.

L'invention concerne également l'utilisation de ces types de gaines pour lutter contre l'oxydation et/ou l'hydruration dans une atmosphère humide comprenant de l'eau, en particulier sous forme de vapeur d'eau.

L'invention concerne également l'utilisation de ces types de gaines, pour lutter contre l'hydruration dans une atmosphère hydrogénée comprenant de l'hydrogène, en particulier une atmosphère hydrogénée comprenant plus de 50 % molaire d'hydrogène et/ou en outre de l'eau, en particulier sous forme de vapeur d'eau.

L'atmosphère humide ou l'atmosphère hydrogénée peut en outre comprendre un gaz additionnel choisi parmi l'air, l'azote, le dioxyde de carbone ou leurs mélanges.

Préférentiellement, ces utilisations ont pour but de lutter contre l'oxydation et/ou l'hydruration :
- dans laquelle l'atmosphère humide ou hydrogénée est à une température comprise entre 25 °C et 1400 °C, voire entre 25 °C et 1600 °C, plus particulièrement une température comprise entre 200 °C et 1300 °C, encore plus particulièrement entre 1200 °C et 1300 °C, voire entre 1300 °C et 1600 °C ; et/ou
- jusqu'à au moins 5000 secondes, plus particulièrement entre 1000 secondes et 5000 secondes, en particulier lorsque la température est comprise entre 1200 °C et 1300 °C ; et/ou
- en présence d'une vitesse de montée en température qui est comprise entre 0,1 °C/secondes et 300 °C/secondes ; et/ou
- suite à une trempe à l'eau de la gaine de combustible nucléaire, en particulier dans laquelle la trempe se déroule à une température comprise entre 25 °C et 400 °C.

### EXPOSE DETAILLE DE L'INVENTION

Dans la présente description de l'invention, un verbe tel que « comprendre », « incorporer », « inclure », « contenir », « composé de » et ses formes conjuguées sont des termes ouverts et n'excluent donc pas la présence d'élément(s) et/ou étape(s) additionnels s'ajoutant aux élément(s) et/ou étape(s) initiaux énoncés après ces termes. Toutefois, ces termes ouverts visent en outre un mode de réalisation particulier dans lequel seul(s) le(s) élément(s) et/ou étape(s) initiaux, à l'exclusion de tout autre, sont visés ; auquel cas le terme ouvert vise en outre le terme fermé « consister en », « constituer de » et ses formes conjuguées.

L'expression « et/ou » vise à relier des éléments en vue de désigner à la fois un seul de ces éléments, les deux éléments, voire leur mélange ou leur combinaison.

L'usage de l'article indéfini « un » ou « une » pour un élément ou une étape n'exclut pas, sauf mention contraire, la présence d'une pluralité d'éléments ou étapes.

Tout signe de référence entre parenthèses dans les revendications ne saurait être interprété comme limitatif de la portée de l'invention.

Par ailleurs, sauf indication contraire, les valeurs aux bornes sont incluses dans les gammes de paramètres indiquées et les températures indiquées sont considérées pour une mise en oeuvre à pression atmosphérique.

Le procédé de fabrication de l'invention vise à réaliser une gaine de combustible nucléaire comprenant :
i) un substrat contenant une couche interne à base de zirconium destinée à être contact ou en vis-à-vis avec le combustible nucléaire ; et
ii) au moins une couche externe à base de chrome placée sur le substrat et destinée à protéger la gaine vis-à-vis du milieu extérieur, en particulier le caloporteur.

Préférentiellement, au moins une couche intercalaire est placée entre la couche interne et la couche externe vis-à-vis desquelles elle joue le rôle de barrière de diffusion. Dans ce mode de réalisation, le substrat est formé par la combinaison de la couche interne et de la au moins une couche intercalaire.

La gaine peut également comprendre un revêtement interne placé sous la couche interne, dont l'épaisseur est par exemple comprise entre 50 µm et 150 µm. Le revêtement interne peut comprendre une ou plusieurs couches. Il constitue un « liner » interne qui améliore la robustesse de la gaine vis-à-vis des interactions physico-chimiques et mécaniques avec le combustible. Il est généralement obtenu par co-filage à chaud lors de la fabrication de la couche interne.

La couche interne est à base zirconium, à savoir qu'elle est composée de zirconium à plus de 50 % en poids, particulièrement plus de 90 %, voire plus de 95 %.

Plus précisément, la couche interne et/ou le revêtement interne est composé de zirconium ou d'un alliage de zirconium. L'alliage de zirconium peut comprendre en poids :
- de 0 % à 3 % de niobium ; préférentiellement 0 % à 1,2 % ;
- de 0 % à 2 % d'étain ; préférentiellement 0 % à 1,3 % ;
- de 0 % à 0,5 % de fer ; préférentiellement de 100 ppm à 2000 ppm ;
- de 0 % à 0,2 % de chrome ;
- de 0 % à 0,2 % de nickel ;
- de 0 % à 0,2 % de cuivre ;
- de 0 % à 1 % de vanadium ;
- de 0 % à 1 % de molybdène ;
- de 0,05 % à 0,2 % d'oxygène.

L'alliage de zirconium est par exemple le Zircaloy-2 ou le Zircaloy-4.

L'alliage de zirconium peut en particulier être choisi parmi un alliage répondant aux contraintes du domaine nucléaire, par exemple le Zircaloy-2, le Zircaloy-4, le Zirlo™, l'Optimized-Zirlo™ ou le M5™. Les compositions de de ces alliages sont telles qu'ils comprennent en poids, par exemple :
- alliage Zircaloy-2 : 1,20 % à 1,70 % de Sn ; 0,07 % à 0,20 % de Fe ; 0,05 % à 1,15 % de Cr ; 0,03 % à 0,08 % de Ni ; 900 ppm à 1500 ppm d'O ; le reste de zirconium.
- alliage Zircaloy-4 : 1,20 % à 1,70 % de Sn ; 0,18 % à 0,24 % de Fe ; 0,07 % à 1,13 % de Cr ; 900 ppm à 1500 ppm d'O ; moins de 0,007 % de Ni ; le reste de zirconium.
- alliage Zirlo™ : 0,5 % à 2,0 % de Nb ; 0,7 % à 1,5 % de Sn ; 0,07 % à 0,28 % d'au moins un élément choisi parmi Fe, Ni, Cr ; jusqu'à 200 ppm de C ; le reste de zirconium.
- alliage Optimized-Zirlo™ : 0,8 % à 1,2 % de Nb ; 0,6 % à 0,9 % de Sn ; 0,090 % à 0,13 % de Fe ; 0,105 % à 0,145 % d'O ; le reste de zirconium.
- alliage M5™ : 0,8 % à 1,2 % de Nb ; 0,090 % à 0,149 % d'O ; 200 ppm à 1000 ppm de Fe ; le reste de zirconium.

La au moins une couche externe placée sur le substrat est composée d'une matière protectrice choisie parmi le chrome ou un alliage de chrome, en particulier tout alliage de chrome apte à être utilisé dans le domaine nucléaire et/ou sous irradiation.

Plus particulièrement, l'alliage de chrome composant la matière protectrice peut comprendre au moins un élément d'addition choisi parmi le silicium, l'yttrium ou l'aluminium, par exemple à une teneur de 0,1 % à 20 % atomique.

La au moins une couche externe a éventuellement une structure colonnaire.

Préférentiellement, les grains colonnaires constitutifs de la structure colonnaire ont un diamètre moyen de 100 nm à 10 µm.

La au moins une couche externe à base de chrome est déposée sur le substrat avec le procédé de fabrication de l'invention selon les étapes successives suivantes :
a) décapage ionique de la surface du substrat ;
b) dépôt sur le substrat avec un procédé de pulvérisation cathodique magnétron par impulsions de forte puissance (HiPIMS) de la au moins une couche externe.

La cathode magnétron constituant la cible est alors composée de la matière protectrice.

Les étapes a) et b) sont réalisées sur la dernière couche du substrat, à savoir sur la couche interne à base de zirconium ou sur la dernière couche intercalaire selon que le substrat contient respectivement une couche interne revêtue ou non d'au moins une couche intercalaire.

Afin de placer au moins une couche intercalaire sur la couche interne, on peut réaliser les étapes successives suivantes réalisées avant l'étape a) de décapage :
a') décapage ionique de la surface de la couche interne ;
b') obtention d'un substrat par dépôt de la au moins une couche intercalaire sur la couche interne avec un procédé de pulvérisation cathodique magnétron par impulsions de forte puissance (HiPIMS) dans lequel la cathode magnétron est composée de la au moins une matière intercalaire.

Ce mode de réalisation constitue un cas particulier du procédé de fabrication de la gaine de combustible nucléaire composite selon l'invention, en ce que la au moins une couche intercalaire est déposée avec un procédé de pulvérisation HiPIMS.

La distance séparant le substrat et la cathode magnétron utilisée selon l'étape de décapage a) ou a') et/ou l'étape de dépôt b) ou b') peut être comprise entre 40 mm et 150 mm.

Le décapage ionique selon l'étape a) et/ou a') peut être réalisé avec un procédé de décapage HiPIMS ou un procédé de décapage par arc cathodique.

La mise en oeuvre du procédé de pulvérisation HiPIMS selon l'étape b) ou b') nécessite l'établissement d'une tension de polarisation à l'aide d'impulsions de polarisation appliquées sur la cible contenue dans le réacteur de pulvérisation cathodique.

La cathode magnétron peut-être une cathode plane, ou une cathode creuse par exemple cylindrique.

Les gammes de valeurs qui suivent concernant les tensions de polarisation et les impulsions de polarisation sont données à titre indicatif pour une cathode magnétron d'une surface de 300 cm². L'homme du métier peut en particulier adapter les valeurs indiquées pour les impulsions de polarisation appliquées sur la cathode magnétron afin de respecter la gamme de densité de puissance préconisée, sachant que la tension de polarisation à appliquer varie de manière inversement proportionnelle à la surface de la cible.

Le procédé de décapage HiPIMS utilisé à l'étape a) et/ou a') peut comprendre la polarisation de la cathode magnétron avec une tension comprise entre - 1000 V et - 500 V.

Le procédé de décapage par arc cathodique selon l'étape a) et/ou a') peut comprendre la polarisation d'une cathode arc avec une tension comprise entre - 20 V et - 50 V ou selon une intensité de 50 A à 250 A.

Le procédé de décapage HiPIMS ou par arc cathodique selon l'étape a) et/ou a') peut comprendre la polarisation du substrat avec une tension comprise entre - 800 V et - 600 V.

Les ions Cr⁺ produits lors de l'étape a) et/ou a') décapent la surface du substrat en vue d'améliorer l'adhérence de la couche externe à déposer.

Le procédé de pulvérisation HiPIMS selon l'étape b) et/ou b') comprend généralement le maintien de la polarisation de la cathode magnétron ou de telle sorte que la tension reste comprise entre - 1000 V et - 500 V.

La polarisation du substrat est quant à elle diminuée par rapport à l'étape de décapage selon l'étape a) et/ou a'), par exemple de telle sorte que le procédé de pulvérisation HiPIMS selon l'étape b) et/ou b') comprend la polarisation du substrat avec une tension comprise entre - 200 V et 0 V.

Le procédé de pulvérisation HiPIMS selon l'étape b) et/ou b') peut comprendre l'application sur la cathode magnétron d'impulsions de polarisation dont chacune peut présenter au moins une des caractéristiques suivantes :
- durée de 10 µs à 200 µs ;
- intensité de pic moyenne instantanée de 50 A à 1000 A, par exemple de 50 A à 200 A ;
- puissance instantanée de 50 kW à 2 MW, plus particulièrement de 100 kW à 2 MW ;
- densité de puissance de 0,2 kW/cm² à 5 kW/cm², plus particulièrement 1 kW/cm² à 5 kW/cm² .
Les impulsions de polarisation peuvent être appliquées sur la cathode magnétron selon une fréquence de 50 Hz à 600 Hz, plus particulièrement de 100 Hz à 600 Hz.

Le procédé de décapage HiPIMS selon l'étape a) et/ou a') ou le procédé de pulvérisation HiPIMS selon l'étape b) et/ou b') est réalisé avec un gaz porteur comprenant au moins un gaz rare.

Le gaz rare peut être choisi parmi l'argon, le xénon ou le krypton.

Le gaz porteur est par exemple à une pression comprise entre 0,2 Pa et 2 Pa.

Selon un mode de réalisation particulier du procédé de fabrication de l'invention, après le dépôt sur le substrat de la première couche externe avec le procédé de pulvérisation HiPIMS selon l'étape b) et/ou b'), au moins une partie de la ou des couche (s) externe (s) supplémentaire(s) sont déposées au cours de l'étape b) et/ou b') avec un procédé de pulvérisation cathodique magnétron de type différent du HiPIMS qui est réalisé simultanément avec le procédé de pulvérisation HiPIMS selon l'étape b) et/ou b').

Le procédé de pulvérisation cathodique magnétron de type différent du HiPIMS est par exemple tel que la polarisation de la cible est continue (dit DC pour « Direct Current ») ou pulsée à moyenne fréquence (dit DC pulsé) conduisant à une tension de polarisation délivrant une puissance instantanée de quelques kilowatts.

Le dépôt des couches externes supplémentaires avec un procédé de PVD magnétron conventionnel combiné avec le procédé de pulvérisation HiPIMS selon l'étape b) et/ou b') permet d'améliorer l'industrialisation du procédé de fabrication de l'invention en augmentant la vitesse de dépôt des couches externes supplémentaires.

À l'issue du procédé de fabrication de l'invention, on obtient au moins une couche externe qui a une épaisseur de 1 µm à 50 µm, préférentiellement de 3 µm à 25 µm, encore plus préférentiellement de 3 µm à 10 µm.L'épaisseur cumulée des couches externes est généralement de 1 µm à 50 µm, voire 2 µm à 50 µm.

Plusieurs couches externes peuvent être déposées sur le substrat. Par exemple, la gaine de combustible nucléaire comprend de 1 à 50 couches externes, afin de constituer un revêtement externe multicouche. Le cas échéant, les couches externes peuvent fusionner en une seule couche externe afin de constituer un revêtement externe monocouche, par exemple après application d'un traitement thermique sur les couches externes ou en variant les conditions de décapage et de dépôt.

Selon un mode de réalisation préférentiel du procédé de fabrication de l'invention, la au moins une couche intercalaire est composée d'au moins une matière intercalaire choisie parmi le tantale, le molybdène, le tungstène, le niobium, le vanadium, le hafnium ou leurs alliages.

Une telle couche intercalaire constitue une barrière de diffusion qui limite voire empêche :
- la diffusion du chrome de la couche externe vers la couche interne à base de zirconium, ce qui conduit à une consommation accélérée de la ou des couche(s) externe(s) en plus de son oxydation en chromine ;
- la formation d'un eutectique au-delà de 1330 °C environ, ce qui peut potentiellement nuire à la tenue mécanique des gaines de combustible et leur capacité à être refroidies.

Préférentiellement, la matière intercalaire est le tantale.

Le tantale ou son alliage peut être remplacé ou combiné avec au moins un élément métallique réfractaire ou son alliage, dont les propriétés physico-chimiques sont compatibles avec la couche interne à base de zirconium jusqu'à 1300 °C. En particulier, jusqu'à 1300 °C, l'élément métallique réfractaire ou son alliage ne forme pas d'eutectique et présente une diffusion limitée dans le zirconium et/ou le chrome.

Outre le tantale, un tel élément métallique réfractaire est par exemple le molybdène, le tungstène ou le niobium.

D'autres objets, caractéristiques et avantages de l'invention vont maintenant être précisés dans la description qui suit de modes de réalisation particuliers du procédé de l'invention, donnés à titre illustratif et non limitatif, en référence aux figures annexées.

### BREVE DESCRIPTION DES FIGURES

Les Figures 1A et 1B représentent des clichés de Microscopie Electronique à Balayage de type Canon à Emission de Champ (MEB-FEG) illustrant l'état de surface d'une plaquette de Zircaloy-4 pourvue respectivement d'un revêtement de chrome déposé avec un procédé de PVD magnétron conventionnel et d'une couche externe de chrome déposée avec un procédé de pulvérisation HiPIMS selon l'invention.
La Figure 1C représente le cliché obtenu par microscopie électronique à balayage avec canon à émission de champ d'une coupe de la plaquette de la Figure 1B.
La Figure 1D représente le cliché obtenu par Microscopie Electronique en Transmission (MET) de la région d'interface entre le substrat et la couche externe de la plaquette de la Figure 1B.
Les Figures 1E, 1F et 4G représentent les clichés obtenus par MET en haute résolution et les clichés de diffraction électronique associés de la région d'interface.
Les Figures 2A et 2B représentent des clichés de Microscopie Electronique à Balayage (MEB) d'une coupe transversale réalisée dans l'épaisseur des plaquettes illustrées respectivement sur les Figures 1A et 1B, après qu'elles aient été soumises à une oxydation de 300 s à 1200 °C.
Les Figures 3A et 3B illustrent les concentrations massiques correspondantes mesurées avec une microsonde électronique pour les éléments zirconium, chrome, fer et oxygène en fonction de la distance en micromètres par rapport à l'interface métal. Cette interface est celle séparant la couche externe de chrome (ou le cas échéant le substrat en Zircaloy-4 si toute la couche externe de chrome a été oxydée en Cr₂O₃) de la couche externe d'oxyde de chrome Cr₂O₃.
La Figure 4 représente un cliché en microscopie optique d'une coupe transversale réalisée dans l'épaisseur d'une plaquette similaire à celle de la Figure 1B après une oxydation à 1300 °C.
La Figure 5 illustre le profil de concentration massique du chrome en fonction de la distance en micromètres par rapport à l'interface Zircaloy-4 / couche externe de chrome pour des plaquettes similaires à celles obtenues dans la Figure 1B et pourvues (courbe en pointillé notée « Cr + Ta ») ou non (courbes continues notée « Cr ») d'une couche intercalaire de tantale.
Les Figures 6A et 6B représentent des clichés MEB d'une coupe transversale réalisée dans l'épaisseur des plaquettes illustrées respectivement sur les Figures 1A et 1B, après qu'elles aient été soumises à une oxydation sous vapeur d'eau de 15000 s à 1000 °C.
Les Figures 7A et 7B représentent des vues schématiques en coupe transversale d'une gaine de combustible nucléaire de forme tubulaire, respectivement démunie et pourvue d'une couche intercalaire.

### EXPOSE DE MODES DE REALISATION PARTICULIERS

### 1. Fabrication d'une plaquette à l'aide du procédé de l'invention.

Cet exemple de réalisation du procédé de fabrication de l'invention est effectué dans un réacteur de pulvérisation cathodique commercialisé par la société BALZERS (modèle BAK 640) et équipé d'un générateur Hüttinger. Les conditions expérimentales appliquées peuvent néanmoins varier en fonction du réacteur utilisé ou de sa configuration magnétique, de la forme et de la taille de la cible, ...

Conformément à ses connaissances générales, l'homme du métier peut toutefois aisément s'adapter à ces variations en modifiant au moins un des paramètres tels que par exemple la tension de polarisation du substrat appliquée lors de l'étape a) de décapage ionique ou l'étape b) de dépôt de la couche interne, la durée, la fréquence, l'intensité ou la tension de polarisation des impulsions de polarisation, la distance entre la cible de chrome et le substrat, ou la pression du gaz porteur.

Plus particulièrement, ces paramètres influent sur l'énergie moyenne des ions Cr⁺ produits lors des étapes a) ou b). Cette énergie peut conditionner la densité, l'homogénéité, la texture, la microstructure ou l'état de contrainte de la couche externe.

### 1.1. Étape de décapage ionique.

Une plaquette de Zircaloy-4 de dimension 45 mm x 14 mm x 1,2 mm est dégraissée dans une lessive alcaline, rincée à l'eau et nettoyée aux ultra-sons dans de l'éthanol.

Elle est ensuite placée dans un réacteur de pulvérisation cathodique HiPIMS contenant une cathode magnétron de chrome placée à une distance généralement comprise entre 6 cm et 8 cm, et ici de 8 cm. L'enceinte du réacteur est placée sous un vide inférieur à 2.10⁻⁵ mbar puis remplie d'un gaz porteur composé d'argon à une pression de 0,5 Pa.

La plaquette constituant la couche interne, et donc le substrat à revêtir, est polarisée négativement avec une tension de polarisation de - 800 V.

La cible de chrome est ensuite alimentée à l'aide du générateur HiPIMS selon une tension de polarisation de - 800 V afin de générer une décharge fortement ionisée. Le chrome est alors pulvérisé sous forme d'ions qui sont accélérés par le champ électrique du substrat. Les espèces carbonées adsorbées et la couche nanométrique d'oxyde ou d'hydroxyde de zirconium natif sont alors retirées de la surface du substrat afin d'améliorer l'adhérence de la couche externe. Ce décapage ionique du substrat dure 3 minutes afin de limiter l'échauffement de la plaquette.

### 1.2. Étape de dépôt de la couche externe par pulvérisation HiPIMS.

La tension de polarisation appliquée à la plaquette décapée est par exemple diminuée entre - 50 V et 0 V, dans le cas présent à - 50 V pendant 8 heures. La vitesse de dépôt étant généralement comprise entre 0,5 µm/h et 1 µm/h, ces conditions mènent au dépôt d'une couche externe de chrome d'une épaisseur de 6 µm.

La tension de polarisation de la cible chrome est maintenue à - 800 V. Plusieurs impulsions de polarisation sont appliquées sur la cathode magnétron selon les caractéristiques suivantes :
- durée d'une impulsion = 40 µs ;
- fréquence des impulsions = 500 Hz ;
- intensité moyenne globale = environ 2 A ;
- intensité moyenne instantanée = environ 100 A ;
- puissance moyenne globale = environ 1 kW ;
- puissance moyenne instantanée pour une impulsion = 60 kW.

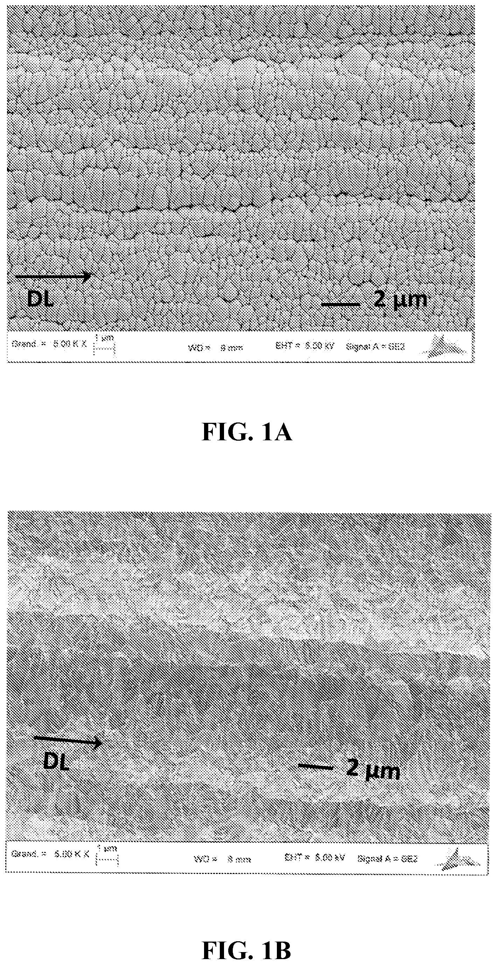

L'état de surface de la plaquette revêtue de la couche externe de chrome est illustré par la Figure 1B. À titre comparatif, la Figure 1A illustre une morphologie de surface très différente obtenue pour une plaquette témoin de Zircaloy-4 sur laquelle un revêtement de chrome de même épaisseur a été déposé à l'aide d'un procédé de PVD magnétron conventionnel similaire à celui décrit dans l'exemple 1 de « WO 2013/160587 ».

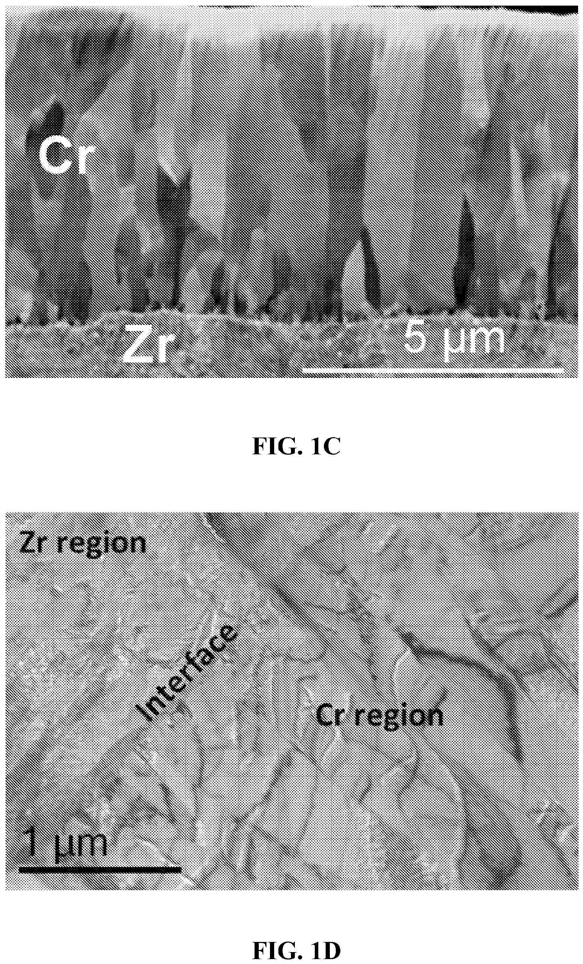

La Figure 1C illustre la structure en grains colonnaires de la couche externe à base de chrome.

La Figure 1D illustre de nouveau la structure colonnaire de la couche externe, ainsi que la présence d'une couche d'interface.

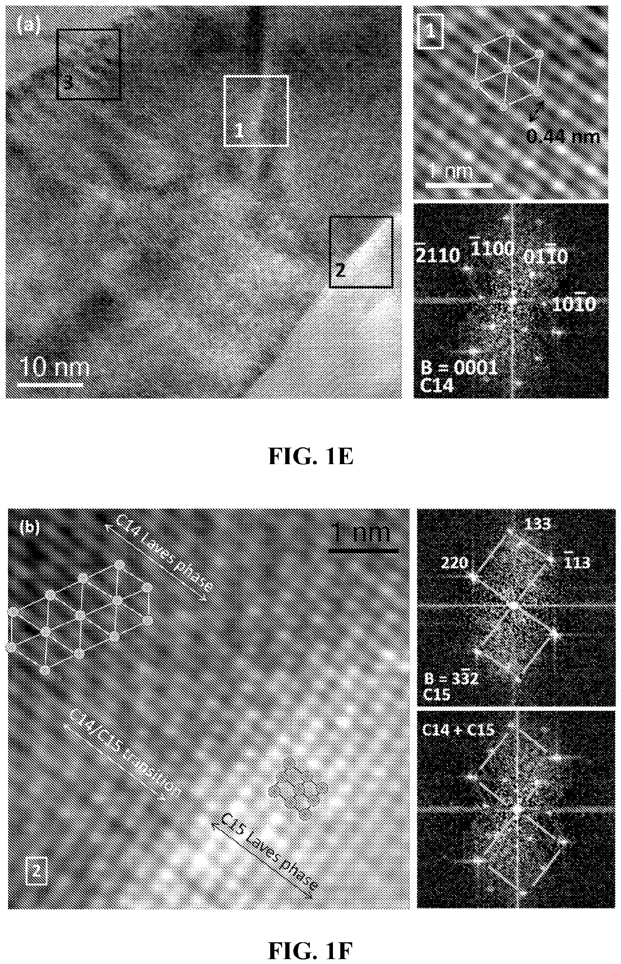

La Figure 1E montre les zones 1, 2 et 3 de la région d'interface qui sont respectivement positionnées au milieu de la région d'interface, entre le substrat à base de zirconium et la région d'interface, entre la couche externe à base de chrome et la région d'interface. Elle illustre également la zone 1 et les paramètres structuraux qui identifient le composé intermétallique Zr(Fe,Cr)₂ de structure cristalline hexagonale dont cette zone est composée.

La Figure 1F illustre la zone 2 et les paramètres structuraux qui identifient le composé intermétallique ZrFe₂ de structure cristalline cubique dont cette zone est composée.

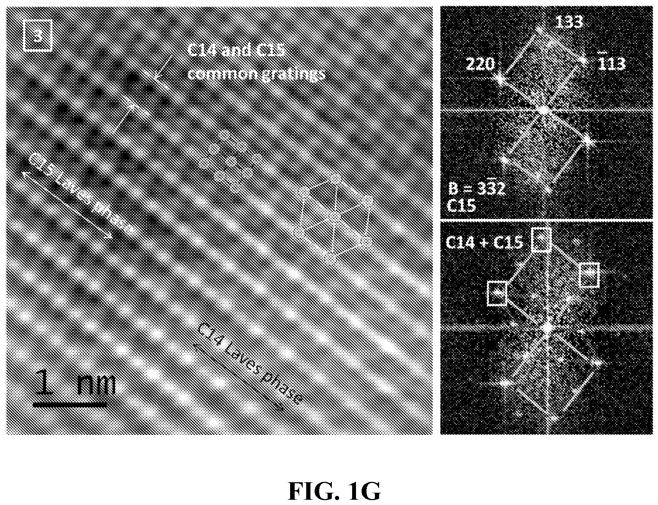

La Figure 1G illustre la zone 3 et les paramètres structuraux qui identifient le composé intermétallique ZrCr₂ de structure cristalline cubique dont cette zone est composée.

L'ensemble des Figures 1E, 1F et 1G montre donc que la composition de la couche d'interface évolue progressivement de l'interface avec le substrat en Zircaloy-4 vers l'interface avec la couche externe de chrome selon l'ordre suivant des composés intermétalliques : ZrFe₂, Zr(Fe,Cr)₂, ZrCr₂. Contre toute attente, les phases nanométriques ZrFe₂ et Zr(Fe,Cr)₂ contenant du fer ont été formées par interaction de l'alliage de zirconium du substrat avec le chrome.

### 2. Propriétés vis-à-vis de l'oxydation/hydruration.

### 2.1. Évaluation de la résistance à l'oxydation en conditions accidentelles à 1200 °C.

Afin d'évaluer sa résistance à l'oxydation, une plaquette à base de Zircaloy-4 pourvue d'une unique couche externe de chrome de 6 µm conformément à l'exemple 1 séjourne pendant 300 secondes dans un four dans lequel circule de la vapeur d'eau portée à 1200 °C.

À titre comparatif, la même expérience est réalisée avec une plaquette témoin de Zircaloy-4 qui a été recouverte d'un revêtement de chrome de même épaisseur à l'aide d'un procédé de pulvérisation cathodique conventionnel conformément à l'exemple 1 de « WO 2013/160587 ».

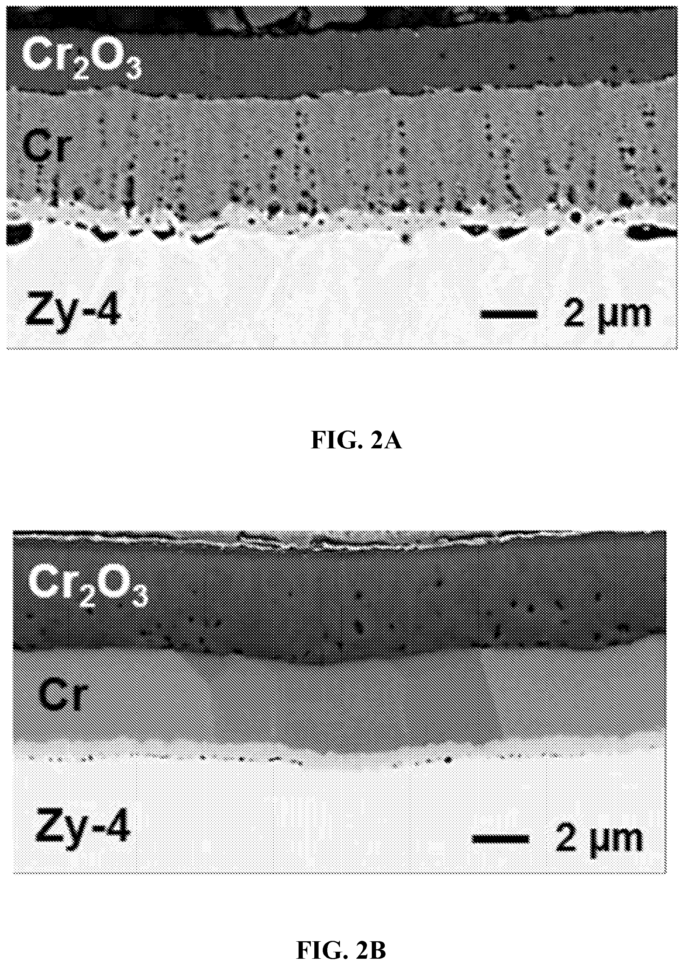

L'état des plaquettes obtenues à l'issue de cette oxydation est illustré par les Figures 2A et 2B.

La Figure 2A montre qu'une couche d'oxyde de chrome Cr₂O₃ d'épaisseur limitée se forme. Le revêtement de chrome déposé selon le procédé de l'état de la technique possède donc un caractère partiellement protecteur vis-à-vis de l'oxydation à 1200 °C. Néanmoins, des porosités et des fissures sont présentes dans la couche de chrome métallique résiduelle se situant sous la couche d'oxyde de chrome Cr₂O₃. Elles résultent notamment d'une desquamation à l'interface entre le substrat de Zircaloy-4 et le revêtement de chrome, ce qui traduit une fragilisation de la couche de chrome métallique résiduelle de la plaquette témoin et une dégradation de ses propriétés de résistance à l'oxydation, notamment par perte d'étanchéité vis-à-vis de la diffusion de l'oxygène.

En revanche, même si la Figure 2B illustre la formation d'une couche périphérique d'oxyde de chrome Cr₂O₃ d'épaisseur supérieure, la couche sous-jacente de chrome métallique résiduelle initialement déposée avec le procédé de pulvérisation HiPIMS n'est quant à elle pas dégradée. Ceci est confirmé par l'absence de desquamation à l'interface avec la couche interne de Zircaloy-4, ainsi que par une très faible quantité de porosités. Cette microstructure préservée confirme le caractère protecteur du revêtement de chrome vis-à-vis de l'oxydation/hydruration de l'alliage de zirconium jusqu'à au moins 1200 °C, en particulier sa capacité à limiter la diffusion de l'oxygène dans la couche interne de Zircaloy-4.

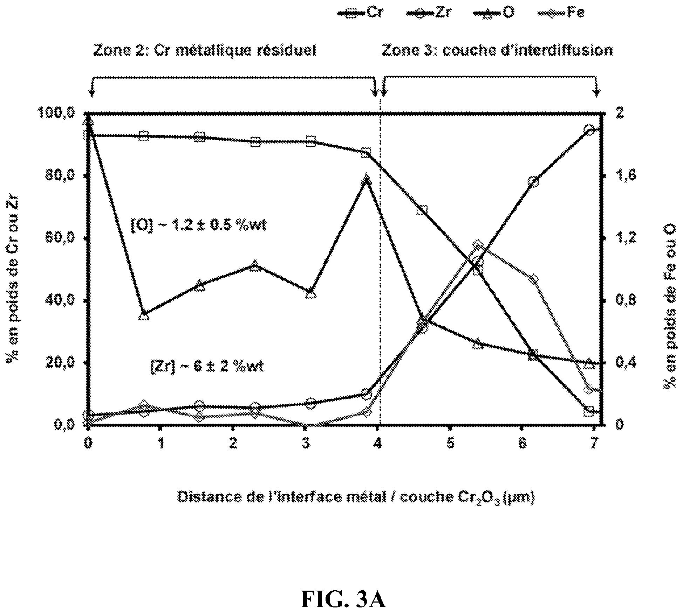

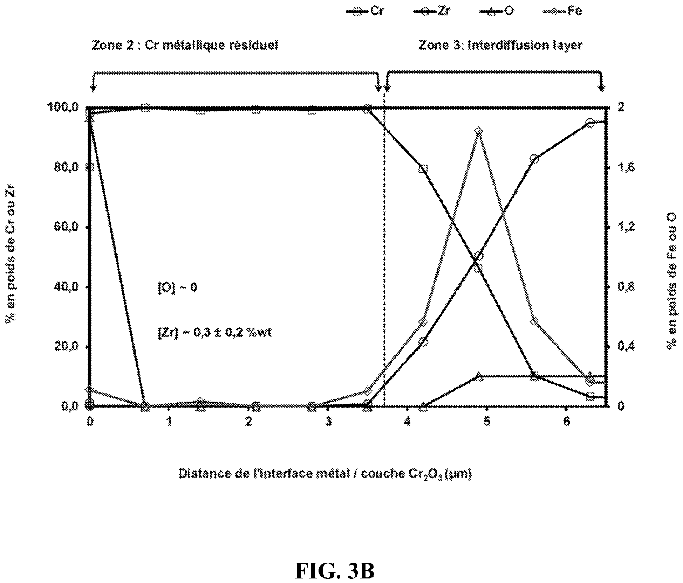

De tels résultats sont confirmés par les Figures 3A et 3B qui illustrent les profils de diffusion du zirconium, du chrome et de l'oxygène mesurés à la microsonde électronique dans l'épaisseur du revêtement et au voisinage de l'interface Zircaloy-4 / chrome.

On peut observer l'absence de diffusion d'oxygène mesurable au sein de la couche métallique résiduelle du revêtement HiPIMS et a fortiori dans la couche interne à base de zirconium.

Pour la plaquette témoin, les mesures de la Figure 3A montrent une diffusion significative d'oxygène au travers du revêtement de chrome qui présente une teneur moyenne en oxygène d'environ 1 % massique. Cette diffusion se poursuit au sein même du Zircaloy-4 dans lequel la teneur en oxygène est de l'ordre de 0,3 % à 0,4 % massique dans les premiers 100 µm à partir de l'interface revêtement de chrome / substrat de Zircaloy-4.

Pour la plaquette réalisée conformément au procédé de fabrication de l'invention, les mesures de la Figure 3B montrent que la teneur moyenne en oxygène dans le Zircaloy-4 est quasi-identique à la valeur initiale de 0,14 % massique. L'absence de diffusion d'oxygène au sein de la couche résiduelle de chrome et a fortiori du substrat Zircaloy-4 permet de préserver les propriétés mécaniques du substrat, notamment la ductilité et la ténacité résiduelles. Ceci fournit donc une marge de protection bien meilleure vis-à-vis des conséquences néfastes de l'oxydation à 1200 °C.

Par ailleurs, des expériences similaires d'une oxydation à 1200 °C pendant 300 secondes suivie d'une trempe à l'eau à température ambiante ont confirmé un tel comportement lorsque les géométries plaquette sont remplacées par des géométries de gaine tubulaire impliquant pourtant une texture cristalline différente : le gain de masse représentatif de la prise d'oxygène est de 10 à 30 fois inférieur pour le tube réalisé par le procédé de l'invention en comparaison de celui mesuré pour le tube recouvert d'un revêtement de chrome avec un procédé de pulvérisation cathodique conventionnel.

### 2.2. Évaluation de la résistance à l'oxydation en conditions accidentelles à 1300 °C.

Un autre échantillon de la plaquette réalisée conformément au procédé de fabrication de l'invention séjourne pendant 5600 secondes dans une atmosphère équimolaire oxygène/hélium portée à 1300 °C.

Dans ce domaine particulier de température d'oxydation, une telle composition d'atmosphère est raisonnablement représentative des conditions d'oxydation sous vapeur d'eau, car, sauf cas particulier (vapeur confinée, alliage de qualité médiocre, état de surface dégradé, ...), aucune hydruration significative du substrat ne se produit lors de l'oxydation à 1300 °C.

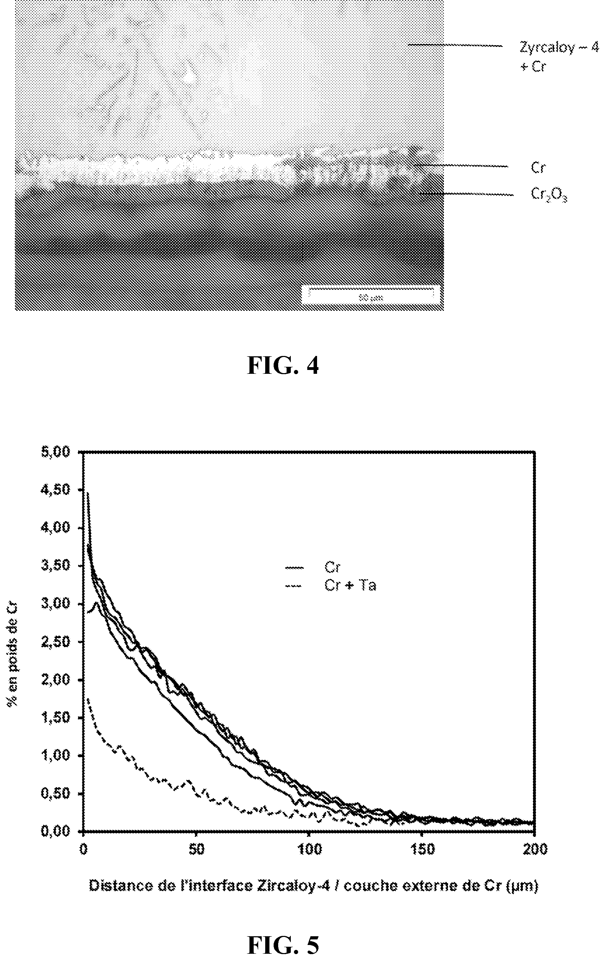

Bien que ces conditions de température se situent plus de 100 °C au-delà des limites réglementaires « APRP », le cliché de la Figure 4 montre que la plaquette d'une épaisseur de 1mm environ n'est pas détruite et que seule une partie de la couche externe de chrome d'une épaisseur initiale de 15 µm à 20 µm a été oxydée en chromine Cr₂O₃.

Le substrat de Zircaloy-4 présente majoritairement une structure de type Zr-ex-β qui assure l'essentiel de la ductilité résiduelle de la plaquette.

En comparaison, la couche interne métallique résiduelle de Zircaloy-4 d'une plaquette témoin non revêtue d'une couche externe de chrome et soumise aux mêmes conditions d'oxydation présente quant à elle une structure entièrement Zr-α(O) fragile à basse température et qui est responsable d'une perte d'intégrité par fissuration traversante.

Même en conditions oxydantes à 1300 °C, très au-delà des limites de sûreté réglementaire, une gaine de combustible nucléaire obtenu par le procédé de fabrication de l'invention peut garder son intégrité mécanique et présenter une marge résiduelle confortable de résistance à l'oxydation/hydruration.

### 2.3. Évaluation de la résistance à l'oxydation avec une couche intercalaire de tantale.

Une plaquette est réalisée dans des conditions similaires à celles de l'exemple 1, si ce n'est qu'une couche intercalaire d'une épaisseur de 2 µm à 3 µm environ composée de tantale est déposée sur la couche interne à l'aide d'un procédé de pulvérisation HiPIMS. Le dépôt de la couche intercalaire de tantale est réalisé selon des conditions similaires à celles du dépôt de la couche externe de chrome pour l'exemple 1, si ce n'est que la cible de tantale est polarisée à -800 V pour une durée d'impulsion de 25 µs. Après la mise en oeuvre du décapage ionique (selon l'étape a) du procédé de fabrication de l'invention) de la couche intercalaire de tantale, une couche externe de chrome d'une épaisseur de 4 µm est ensuite déposée sur cette couche intercalaire conformément à l'étape b) du procédé de fabrication de l'invention.

À titre comparatif, plusieurs plaquettes témoin correspondantes, si ce n'est qu'elles sont dépourvues de couche intercalaire de tantale, sont réalisées.

Après un séjour de 300 secondes dans un four dans lequel circule de la vapeur d'eau à 1200 °C, les profils de diffusion du chrome de la couche externe vers la couche interne de Zircaloy-4 sont mesurés à partir de l'interface entre ces couches.

Ces mesures illustrées dans la Figure 5 montrent :
- une très bonne reproductibilité des résultats obtenus sur les plaquettes témoin dépourvues de couche intercalaire en tantale ;
- une diffusion du chrome dans la couche interne de Zircaloy-4 qui est plus importante pour les plaquettes témoin. À 1200 °C, la couche externe de chrome est en effet consommée à proportion relativement similaire via un phénomène interne de diffusion du chrome vers l'alliage de zirconium et via l'oxydation externe du chrome en oxyde de chrome ;
- l'effet bénéfique en conditions oxydantes à 1200 °C de la couche intercalaire de tantale qui joue le rôle d'une barrière de diffusion : en comparaison avec la plaquette témoin, la quantité totale de chrome qui diffuse de la couche externe vers la couche interne de Zircaloy-4 est ainsi divisée par environ 4 et la durée de vie de la couche externe peut éventuellement être multipliée par 2.

De manière générale, la couche intercalaire réduit voire supprime le phénomène de diffusion, ce qui augmente la durée de vie de la couche externe et donc de la gaine de combustible nucléaire correspondante, notamment en conditions accidentelles telles que par exemple le dénoyage d'une piscine de stockage de combustible usé ou celles définies par les critères d'accident de dimensionnement de type APRP.

Par ailleurs, l'impact de la couche intercalaire sur la diffusion du chrome vers l'alliage de zirconium a également pour avantage de retarder la formation d'un eutectique entre le zirconium et le chrome au-dessus de 1330 °C et donc l'obtention d'une phase liquide en surface, ce qui permet d'éviter ou limiter les conséquences potentiellement négatives qui pourraient en découler en cas d'incursion au-delà de ~1320 °C.

### 2.4. Évaluation de la résistance à l'hydruration à 1000 °C.

L'hydruration est un phénomène se produisant au sein d'une gaine de combustible nucléaire en conditions nominales ou dans certaines conditions accidentelles. L'hydruration résulte de la succession des réactions (1) et (2) suivantes : le zirconium contenu dans la gaine de combustible nucléaire est oxydé par l'eau pressurisée ou la vapeur d'eau selon la réaction

(1) Zr + 2H₂O -> ZrO₂ + 2H₂

, puis une partie de l'hydrogène ainsi libéré diffuse dans l'alliage de zirconium de la gaine et peut former un hydrure avec le zirconium non encore oxydé de la gaine selon la réaction

(2) Zr + xH -> ZrHₓ.

L'indice « x » indique que des hydrures de stoechiométrie variable peuvent être formés, cet indice étant en particulier égal ou inférieur à 2.

Selon la teneur globale en hydrogène et/ou la température, tout ou partie de l'hydrogène va précipiter, le reste restant en solution solide (en insertion dans le réseau cristallin zirconium-alpha).

Par exemple, à 20 °C, la quasi-totalité de l'hydrogène est précipitée sous forme d'hydrures alors que leur dissolution peut être totale à haute température (typiquement supérieure à 600 °C).

L'hydrogène en solution solide, mais surtout sous forme de précipité d'hydrure de zirconium, a pour inconvénient de diminuer la ductilité des alliages de zirconium, et donc de fragiliser la gaine, notamment à basse température. Cette fragilisation est d'autant plus à craindre lorsque l'on cherche à atteindre de forts taux de combustion car, à ces taux, on constate un accroissement de la proportion de zirconium oxydé selon la réaction (1) et donc de la quantité d'hydrures formés selon la réaction (2). Elle conduit alors le plus souvent à la corrosion des alliages industriels usuels à des niveaux néfastes vis-à-vis des critères de sûreté et d'intégrité de la gaine, et peut poser des problèmes pour le transport et l'entreposage post-service.

Observée en conditions nominales sur les alliages de zirconium M5™ ou Zirlo™ d'une gaine de combustible nucléaire, l'hydruration n'est généralement observée en conditions accidentelles qu'au voisinage de 1000 °C, ou vers 800 °C pour des temps d'oxydation plus longs. Ce phénomène, appelé « breakaway », est associé à une augmentation de la cinétique d'oxydation au-delà d'un certain temps critique. Il résulte de l'apparition de fissures et/ou de porosités dans la phase ZrO₂ liées à la présence de contraintes générées à l'interface Zr/ZrO₂ probablement liée à la transformation réversible de ZrO₂ quadratique en ZrO₂ monoclinique. Les conséquences de cette prise d'hydrogène sont, de la même manière qu'en conditions nominales, une fragilisation du matériau au voisinage de 1000 °C pouvant conduire à sa rupture lors d'une trempe ou après un retour à basse température.

Le phénomène de « breakaway » se produit généralement au bout de 5000 secondes à 1000 °C pour un alliage de zirconium tel que le Zircaloy-4 ou M5™.

Afin d'évaluer la résistance à l'hydruration d'une gaine de combustible nucléaire selon l'invention, un autre échantillon de la plaquette réalisée conformément au procédé de fabrication de l'invention séjourne pendant 15000 secondes dans une atmosphère de vapeur d'eau portée à 1000 °C.

À titre comparatif, la même expérience est réalisée avec une plaquette témoin de Zircaloy-4 qui a été recouverte d'un revêtement de chrome de même épaisseur à l'aide d'un procédé de pulvérisation cathodique conventionnel conformément à l'exemple 1 de « WO 2013/160587 ».

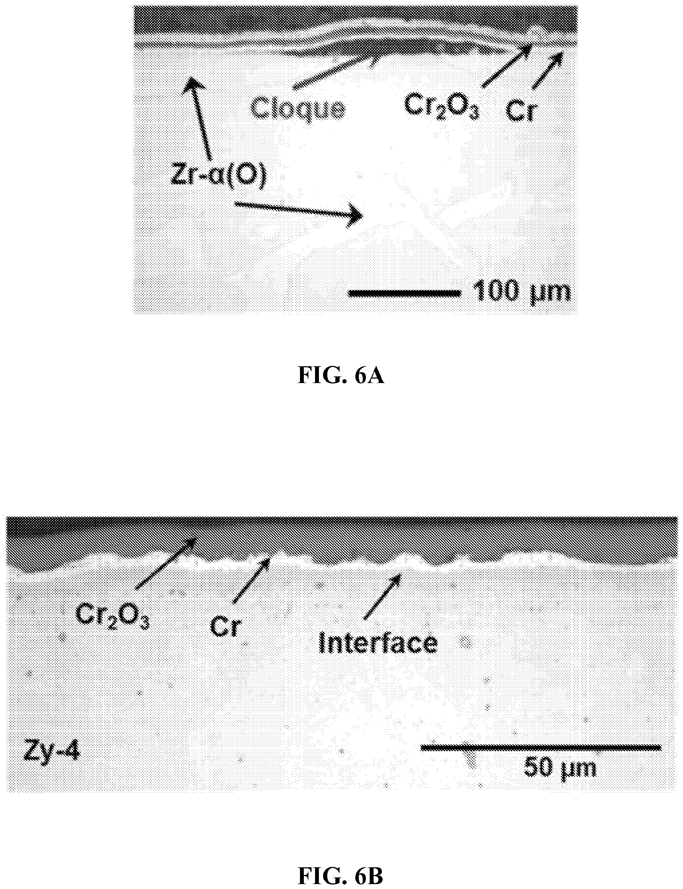

Les résultats obtenus sont illustrés par les Figures 6A et 6B.

La Figure 6A montre que la plaquette témoin présente une desquamation locale de la couche externe de chrome qui est partiellement oxydée en Cr₂O₃. La teneur en hydrogène dissous dans la plaquette est mesurée par analyse des gaz après fusion réductrice dans un analyseur prévu à cet effet, au lieu de l'évaluation indirecte et imprécise selon l'exemple 1 du document « WO 2013/160587 » : cette teneur est d'environ 1000 ppm massique. La plaquette de Zircaloy-4 comprend également des phases de structure Zr-α(O) fragiles à basse température dues à la diffusion d'oxygène dans le Zircaloy-4. Or, il est connu qu'après une trempe à l'eau depuis le domaine Bêta (>900-1000°C), le Zircaloy-4 perd sa ductilité résiduelle à basse température (20-150°C), lorsque la teneur en hydrogène augmente en masse au-delà de 600 ppm environ.

En revanche, la Figure 6B montre que la plaquette réalisée conformément au procédé de fabrication de l'invention présente une couche d'oxyde Cr₂O₃ d'épaisseur 5 fois plus faible que pour la plaquette témoin. De plus, la teneur en hydrogène dissous est au plus de 60 ppm à 80 ppm massique et aucune phase de structure Zr-α(O) n'apparaît dans le substrat à base de zirconium. La plaquette a une ductilité résiduelle significative puisque sa résistance mécanique est quant à elle d'environ 900 MPa et le mode de rupture est ductile transgranulaire à cupules avec un allongement à rupture de plusieurs %. Ces résultats confirment la très bonne résistance à l'hydruration d'une gaine de combustible nucléaire selon l'invention, par exemple dans des conditions « post-breakaway ».

### 3. Géométrie de la gaine de combustible nucléaire selon l'invention.

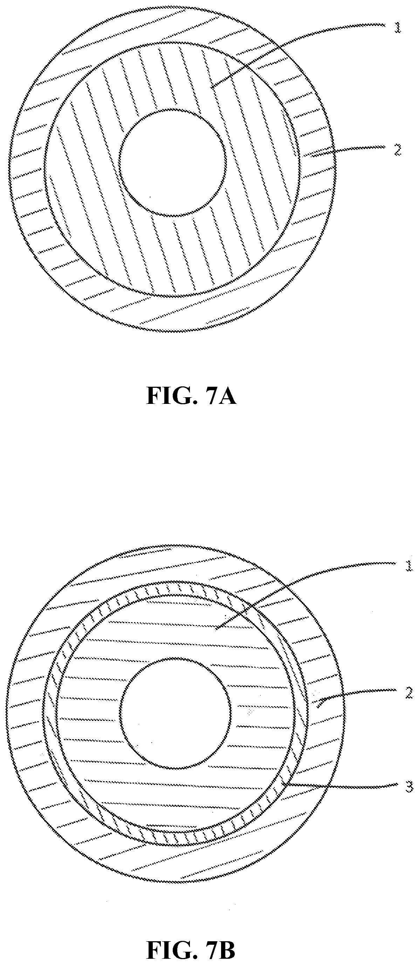

La gaine de combustible nucléaire obtenue par le procédé de fabrication de l'invention est décrite en référence aux Figures 7A et 7B, dans le cas particulier non limitatif d'une géométrie tubulaire.

Selon un premier mode de réalisation de l'invention, la gaine illustrée par la Figure 7A est constituée d'une couche interne à base de zirconium (1) dont la surface interne délimite un volume fermé apte à recevoir le combustible nucléaire. La couche interne (1) forme un substrat sur laquelle est placée une couche externe (2) composée d'une matière protectrice à base de chrome permettant d'améliorer la résistance à l'oxydation de la gaine à très haute température.

Selon un deuxième mode de réalisation illustré par la Figure 7B, la gaine peut être pourvue d'une couche intercalaire (3) placée entre la couche interne (1) et la couche externe (2). Dans ce cas, la combinaison de la couche interne (1) et de la couche intercalaire (3) forme le substrat. La couche intercalaire (3) est composée d'au moins une matière intercalaire, telle que par exemple le tantale, apte à éviter ou limiter la diffusion du chrome de la couche externe (2) vers la couche interne (1).

Selon un troisième mode de réalisation non illustré, un revêtement interne est placé sous la couche interne (1), et donc en vis-à-vis direct avec le volume apte à recevoir le combustible nucléaire.

Il ressort de la description qui précède que le procédé de l'invention permet de fabriquer une gaine de combustible nucléaire présentant une amélioration de la résistance à l'oxydation à très haute température. Les marges de sécurité supplémentaires ainsi obtenues permettent notamment d'éviter ou de retarder la détérioration de la gaine en cas d'aggravation ou de persistance de la situation accidentelle.

## Revendications

1. Procédé de fabrication d'une gaine de combustible nucléaire comprenant i) un substrat contenant une couche interne à base de zirconium (1) revêtue ou non d'au moins une couche intercalaire (3) placée sur ladite couche interne (1), et ii) au moins une couche externe (2) placée sur le substrat et composée d'une matière protectrice choisie parmi le chrome ou un alliage à base de chrome ; le procédé comprenant les étapes successives suivantes :
a) décapage ionique de la surface du substrat ;
b) dépôt de ladite au moins une couche externe (2) sur le substrat avec un procédé de pulvérisation cathodique magnétron par impulsions de forte puissance (HiPIMS) dans lequel la cathode magnétron est composée de la matière protectrice.

2. Procédé de fabrication d'une gaine de combustible nucléaire selon la revendication 1, dans lequel la gaine comprend un revêtement interne placé sous ladite couche interne (1).

3. Procédé de fabrication d'une gaine de combustible nucléaire selon la revendication 1 ou 2, dans lequel ladite au moins une couche intercalaire (3) est placée sur ladite couche interne (1) en réalisant les étapes successives suivantes réalisées avant l'étape a) de décapage :
a') décapage ionique de la surface de ladite couche interne (1) ;
b') obtention d'un substrat par dépôt de ladite au moins une couche intercalaire (3) sur ladite couche interne (1) avec un procédé de pulvérisation cathodique magnétron par impulsions de forte puissance (HiPIMS) dans lequel la cathode magnétron est composée de la au moins une matière intercalaire.

4. Procédé de fabrication d'une gaine de combustible nucléaire selon l'une quelconque des revendications précédentes, dans lequel, après le dépôt sur le substrat de la première couche externe (2) avec ledit procédé de pulvérisation HiPIMS selon l'étape b), au moins une partie de la ou des couche(s) externe(s) (2) supplémentaire(s) sont déposées au cours de l'étape b) avec un procédé de pulvérisation cathodique magnétron de type différent du HiPIMS qui est réalisé simultanément avec ledit procédé de pulvérisation HiPIMS selon l'étape b).

5. Procédé de fabrication d'une gaine de combustible nucléaire selon l'une quelconque des revendications précédentes, dans lequel ladite au moins une couche intercalaire (3) est composée d'au moins une matière intercalaire choisie parmi le tantale, le molybdène, le tungstène, le niobium, le vanadium, le hafnium ou leurs alliages.

6. Gaine de combustible nucléaire avec couche d'interface comprenant :
i) un substrat contenant une couche interne composée d'un alliage de zirconium comprenant en masse de 100 ppm à 3000 ppm de fer ;
ii) au moins une couche externe (2) placée sur le substrat et composée d'une matière protectrice choisie parmi le chrome ou un alliage à base de chrome, et ;
iii) une couche d'interface disposée entre ladite couche interne (1) et la première couche externe (2) et composée d'une matière interfaciale comprenant au moins un composé intermétallique choisi parmi ZrCr₂ de structure cristalline cubique, Zr(Fe,Cr)₂ de structure cristalline hexagonale ou ZrFe₂ de structure cristalline cubique.

7. Gaine de combustible nucléaire selon la revendication 6, dans laquelle la couche d'interface a une épaisseur moyenne de 10 nm à 1 µm.

8. Gaine de combustible nucléaire selon la revendication 6 ou 7, dans laquelle la gaine comprend un revêtement interne placé sous ladite couche interne (1).

9. Gaine de combustible nucléaire selon l'une quelconque des revendications 6 à 8, dans laquelle chacune de ladite au moins une couche externe (2) a une structure colonnaire.

10. Gaine de combustible nucléaire selon l'une quelconque des revendications 6 à 9, dans laquelle chacune de ladite au moins une couche externe (2) a une épaisseur de 1 µm à 50 µm.

11. Utilisation d'une gaine de combustible nucléaire telle que définie par l'une quelconque des revendications 6 à 10, pour lutter contre l'oxydation et/ou l'hydruration dans une atmosphère humide comprenant de l'eau.

12. Utilisation d'une gaine de combustible nucléaire telle que définie par l'une quelconque des revendications 6 à 10, pour lutter contre l'hydruration dans une atmosphère hydrogénée comprenant de l'hydrogène.

13. Utilisation pour lutter contre l'hydruration selon la revendication 12, dans laquelle l'atmosphère hydrogénée comprend en outre de l'eau.

14. Utilisation pour lutter contre l'oxydation et/ou l'hydruration selon l'une quelconque des revendications 11 à 13, dans laquelle l'atmosphère humide ou l'atmosphère hydrogénée est à une température comprise entre 1200 °C et 1300 °C.

## Patentansprüche

1. Verfahren zur Herstellung einer Kernbrennstoffumhüllung, umfassend i) ein Substrat, das eine Innenschicht (1) auf Zirkoniumbasis enthält, die entweder mit mindestens einer auf der Innenschicht (1) platzierten Zwischenschicht (3) beschichtet ist oder nicht, und ii) mindestens eine Außenschicht (2), die auf dem Substrat platziert ist und aus einem aus Chrom oder einer Legierung auf Chrombasis ausgewählten Schutzmaterial besteht: wobei das Verfahren die folgenden aufeinanderfolgenden Schritte umfasst:
a) lonenätzen der Oberfläche des Substrats;
b) Ablagern der mindestens einen Außenschicht (2) auf dem Substrat mit einem Hochleistungs-Puls-Magnetron-Sputterverfahren (HiPIMS), wobei die Magnetron-Kathode aus dem Schutzmaterial besteht.

2. Verfahren zur Herstellung einer Kernbrennstoffumhüllung nach Anspruch 1, wobei die Umhüllung eine Innenauskleidung umfasst, die unter der Innenschicht (1) platziert ist.

3. Verfahren zur Herstellung einer Kernbrennstoffumhüllung nach Anspruch 1 oder 2, bei dem die mindestens eine Zwischenschicht (3) auf der Innenschicht (1) platziert wird, indem die folgenden aufeinanderfolgenden Schritte vor dem Ätzschritt a) ausgeführt werden:
a') lonenätzen der Oberfläche der Innenschicht (1);
b') Erhalten eines Substrats durch Ablagern der mindestens einen Zwischenschicht (3) auf der Innenschicht (1) mit einem Hochleistungs-Puls-Magnetron-Sputterverfahren (HiPIMS), wobei die Magnetron-Kathode aus dem mindestens einen Zwischenschichtmaterial besteht.

4. Verfahren zur Herstellung einer Kernbrennstoffumhüllung nach einem der vorangegangenen Ansprüche, wobei nach dem Ablagern der ersten Außenschicht (2) auf dem Substrat mit dem HiPIMS-Sputterverfahren gemäß Schritt b) mindestens ein Teil der zusätzlichen Außenschicht(en) (2) mit einem Magnetron-Sputterverfahren eines anderen Typs als HiPIMS abgelagert wird, das gleichzeitig mit dem HiPIMS-Sputterverfahren gemäß Schritt b) durchgeführt wird.

5. Verfahren zur Herstellung einer Kernbrennstoffumhüllung nach einem der vorangegangenen Ansprüche, wobei die mindestens eine Zwischenschicht (3) aus mindestens einem Zwischenmaterial, ausgewählt aus Tantal, Molybdän, Wolfram, Niob, Vanadium, Hafnium oder Legierungen davon, besteht.

6. Kernbrennstoffumhüllung mit einer Grenzflächenschicht, umfassend:
i) ein Substrat, das eine Innenschicht aus einer Zirkoniumlegierung enthält, die Eisen in einer Masse von 100 ppm bis 3000 ppm umfasst;
ii) mindestens eine Außenschicht (2), die auf dem Substrat platziert ist und aus einem Schutzmaterial besteht, das aus Chrom oder einer Legierung auf Chrombasis ausgewählt ist, und;
iii) eine Grenzflächenschicht, die zwischen der Innenschicht (1) und der ersten Außenschicht (2) angeordnet ist und aus einem Grenzflächenmaterial besteht, das mindestens eine intermetallische Verbindung, ausgewählt aus ZrCr₂ mit kubischer Kristallstruktur, Zr(Fe,Cr)₂ mit hexagonaler Kristallstruktur oder ZrFe₂ mit kubischer Kristallstruktur, umfasst.

7. Kernbrennstoffumhüllung nach Anspruch 6, wobei die Grenzflächenschicht eine mittlere Dicke von 10 nm bis 1 µm aufweist.

8. Kernbrennstoffumhüllung nach Anspruch 6 oder 7, wobei die Umhüllung eine Innenauskleidung umfasst, die unter der Innenschicht (1) platziert ist.

9. Kernbrennstoffumhüllung nach einem der Ansprüche 6 bis 8, wobei jede der mindestens einen Außenschicht (2) eine säulenförmige Struktur aufweist.

10. Kernbrennstoffumhüllung nach einem der Ansprüche 6 bis 9, wobei jede der mindestens einen Außenschicht (2) eine Dicke von 1 µm bis 50 µm aufweist.

11. Verwendung einer Kernbrennstoffumhüllung nach einem der Ansprüche 6 bis 10 zum Bekämpfen von Oxidation und/oder Hydratation in einer feuchten Atmosphäre, die Wasser umfasst.

12. Verwendung einer Kernbrennstoffumhüllung nach einem der Ansprüche 6 bis 10 zum Bekämpfen der Hydratation in einer Wasserstoff umfassenden Wasserstoffatmosphäre.

13. Verwendung zum Bekämpfen von Hydratation nach Anspruch 12, wobei die Wasserstoffatmosphäre außerdem Wasser umfasst.

14. Verwendung zum Bekämpfen von Oxidation und/oder Hydratation nach einem der Ansprüche 11 bis 13, wobei die feuchte Atmosphäre oder Wasserstoffatmosphäre eine Temperatur zwischen 1200 °C und 1300 °C aufweist.

## Claims

1. Method for producing a nuclear fuel sheath comprising i) a substrate containing a zirconium-based inner layer (1) optionally coated with at least one intermediate layer (3) positioned on said inner layer (1), and ii) at least one outer layer (2) positioned on the substrate and consisting of a protective material selected from either chromium or a chromium-based alloy, the method comprising the following successive steps:
a) ion-beam etching the substrate surface;
b) depositing said at least one outer layer (2) onto the substrate using a high-power impulse magnetron sputtering (HiPIMS) method, wherein the magnetron cathode consists of the protective material.

2. Method for producing a nuclear fuel sheath according to claim 1, wherein the sheath comprises an inner coating positioned below said inner layer (1).

3. Method for producing a nuclear fuel sheath according to either claim 1 or claim 2, wherein said at least one intermediate layer (3) is positioned on said inner layer (1) by carrying out the following steps in succession before the etching step a):
a') ion-beam etching the surface of said inner layer (1);
b') obtaining a substrate by depositing said at least one intermediate layer (3) onto said inner layer using a high-power impulse magnetron sputtering (HiPIMS) method, wherein the magnetron cathode consists of the at least one separator material.

4. Method for producing a nuclear fuel sheath according to any of the preceding claims, wherein, after the first outer layer (2) is deposited onto the substrate using said HiPIMS method according to step b), at least one part of the additional outer layer(s) (2) is deposited during step b) using a magnetron cathode sputtering method other than HiPIMS, carried out simultaneously with said HiPIMS method according to step b).

5. Method for producing a nuclear fuel sheath according to any of the preceding claims, wherein said at least one intermediate layer (3) consists of at least one separator material selected from among tantalum, molybdenum, tungsten, niobium, vanadium, hafnium, or alloys thereof.

6. Nuclear fuel sheath having an interface layer, comprising:
i) a substrate containing an inner layer consisting of a zirconium alloy comprising from 100 ppm to 3000 ppm iron by weight;
ii) at least one outer layer (2) positioned on the substrate and consisting of a protective material selected from either chromium or a chromium-based alloy, and;
iii) an interface layer that is arranged between said inner layer (1) and the first outer layer (2) and consisting of an interface material comprising at least one intermetallic compound selected from among ZrCr₂ having a cubic crystal structure, Zr(Fe,Cr)₂ having a hexagonal crystal structure, or ZrFe₂ having a cubic crystal structure.

7. Nuclear fuel sheath according to claim 6, wherein the interface layer is of an average thickness of 10 nm to 1 µm.

8. Nuclear fuel sheath according to either claim 6 or claim 7, wherein the sheath comprises an inner coating positioned below said inner layer (1).

9. Nuclear fuel sheath according to any of claims 6 to 8, wherein each of said at least one outer layers (2) has a columnar structure.

10. Nuclear fuel sheath according to any of claims 6 to 9, wherein each of said at least one outer layers (2) is of a thickness of from 1 µm to 50 µm.

11. Use of a nuclear fuel sheath according to any of claims 6 to 10 for preventing oxidation and/or hydride cracking within a humid atmosphere comprising water.

12. Use of a nuclear fuel sheath according to any of claims 6 to 10 for preventing hydride cracking in a hydrogen atmosphere comprising hydrogen.

13. Use for preventing hydride cracking according to claim 12, wherein the hydrogen atmosphere further comprises water.

14. Use for preventing oxidation and/or hydride cracking according to any of claims 11 to 13, wherein the temperature of the humid atmosphere or hydrogen atmosphere is between 1200°C and 1300°C.
